# EUROPEAN PATENT APPLICATION

(11) **EP 0 556 043 A1**
(43) Date of publication of application: **18.08.1993**
(21) Application number: 93300988.8
(22) Date of filing: 11.02.1993
(51) Int. Cl.: H01L 21/00, H01J 37/32, H01J 37/20

(54) **Apparatus for programmed plasma etching tool motion to modify solid layer thickness profiles**

(30) Priority: 13.02.1992 US 834742
(71) Applicant: Hughes Aircraft Company, Los Angeles, California 90045-0066 (US)
(72) Inventor: Bollinger, L.D., Ridgefield, CT 06877 (US); Steinberg, George N., Westport, CT 06880 (US)
(74) Representative: Colgan, Stephen James

(57) **Abstract**

A multi-dimension translation table apparatus for use in a vacuum and corrosive environment of a plasma assisted chemical etching reactor system **10** is configured for long term reliability and low risk of contamination of the plasma environment. The apparatus comprises two stacked linear translation stages **46** each having a lead screw axis **74** coupled to a driving means enclosed within a housing **64** having a regulated environment therein. The stages **46** are stacked in a manner so as to have perpendicular axes of linear motion.

## Description

### BACKGROUND OF THE INVENTION

### Field of the Invention

The present invention relates to an apparatus for moving a plasma region of a plasma reactor with respect to a substrate surface, and more particularly, to an apparatus to provide relative, precise, programmable, and two-dimensional motion of a solid layer of a substrate under a small plasma assisted chemical etching reactor located within a corrosive vacuum environment.

### Description of the Prior Art

Plasma assisted chemical etching reactors are used to modify solid layer thickness profiles of substrates by removing material from the surface at a particular location on the surface. Such plasma assisted chemical etching reactor system apparatus generally comprise a housing which encompasses the following components: a plasma region, a substrate which is to receive the plasma etching treatment, and a programmable two-dimensional translation table and movement means to move the substrate surface under the plasma region. Within the confines of the housing, the apparatus is subjected to very low pressures and a corrosive environment, which are both necessary to the plasma etching process. Because the two-dimensional translational table hardware is subjected to this harsh environment, long term reliability of such hardware suffers. Also, the location of the mechanical hardware including the movement means within the housing creates the risk that such hardware will contaminate the vacuum environment.

The present invention is directed to an improvement over previous systems for moving the substrate with respect to the plasma etching region.

### SUMMARY OF THE INVENTION

The present invention is directed to an apparatus for performing programmed plasma etching. The apparatus of the present invention comprises a multi-dimensional translation stage and movement means which is completely disposed within the vacuum chamber of a plasma assisted chemical etching reactor system. During system operation, a very low pressure and corrosive environment exists within the chamber. Because the harsh environment reduces the reliability of the translation stage and its motivating means and because there is an increased risk that the motivating means may contaminate the vacuum chamber, the present invention encloses the motivating means within a housing so as to isolate it from the harsh environment. Ventilation from the atmosphere is provided to the housing along with electrical power to energize the motivating means and position and velocity sensors by a flexible conduit. The translational stage and its motivating means are arranged so that they may be disposed completely within the chamber without unnecessary enlargement of the chamber.

One objective of the present invention is to provide a means to move a substrate surface with respect to a plasma region so as to allow precise optical figuring, film thickness profiling or subsurface damage removal of a substrate.

Another objective of the present invention is to provide a movement means which has long term reliability within a corrosive and very low pressure environment.

Another objective of the present invention is to provide a movement means which will not contaminate the reactive environment.

Other objects and advantages of the present invention will become apparent to those skilled in the art from the following detailed description read in conjunction with the attached drawings and claims appended hereto.

### DESCRIPTION OF THE DRAWINGS

Fig. 1 shows a side view schematic diagram of a plasma assisted chemical etching reactor apparatus illustrating the placement of the multi-dimensional translational stage of the present invention therein.

Fig. 2 shows a top view schematic diagram of a linear translational stage and motivating means of the present invention.

Fig. 3 shows a top view schematic diagram of two stacked linear translational stage of the present invention providing two-dimensional perpendicular motion.

### DETAILED DESCRIPTION OF THE PRESENT INVENTION

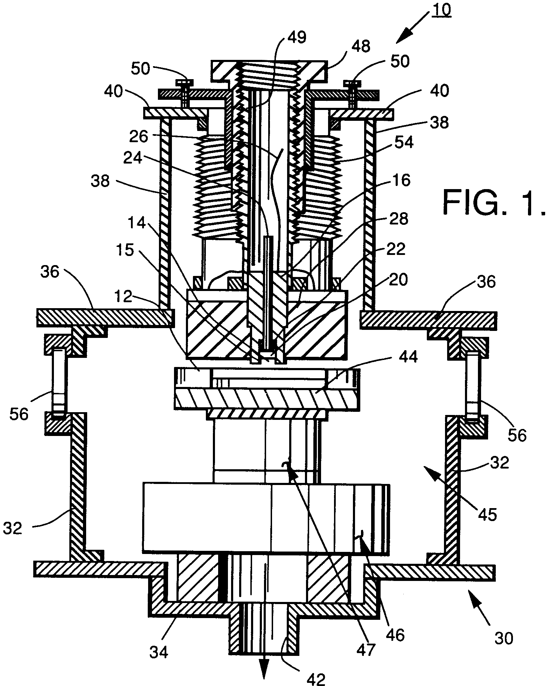

Figure 1 illustrates a plasma assisted chemical etching reactor apparatus used for performing optical figuring, film thickness profiling or subsurface damage removal of a substrate. Referring to Figure 1, the apparatus is designed so as to confine a plasma etch region over a substrate. It comprises a reactor **10** designed for transporting a process gas into a region over the surface of a substrate when an rf field is applied to disassociate the gas into reactive components. To accomplish this desired result, the reactor **10** has a plasma chamber **14** having walls **15** defined by a first dielectric insulator **16** and a ceiling **18** defined by a reactive gas diffuser **20**. The plasma chamber **14** is the center of etching reactivity and thus, the first dielectric must be fabricated from a non-contaminating material. Above the chamber **14**, an rf driven electrode **22** is affixed between the diffuser **18** and the first insulator **16**. A process gas feed tube **24** running centrally through the first dielectric insulator **16** supplies reactive gas to the diffuser **20** in the plasma chamber **14** during the etching operation. An rf inlet conductor **26** connects the rf driven electrode **22** to an rf field power source. A second dielectric insulator **28** surrounds the first insulator **16** and is dimensioned so as to essentially cover substrate **12** so as to prevent plasma formation outside of chamber **14**. The components of the reactor **10**, are enclosed in a vacuum housing **30** comprising a first set of walls **32** extending from a base **34** to a mid-ceiling **36** and a second set of walls **38** extending to a top ceiling flange **40**.

During operation, a vacuum is applied through a vacuum outlet **42** at the bottom of the vacuum housing **30**. The etchable substrate **12**, located adjacently below the plasma chamber **14** during etching, is supported by a substrate holder **44** which also acts as a second electrode having its potential preferably at electrical ground. The substrate holder may also have a device (not shown) to control the temperature of the substrate thereon.

The substrate holder **44** is mounted to an apparatus **45** for two-dimensional translation which allows precise placement of the localized etching reaction on the surface of the substrate **12**. The reactor **10** has a threaded tube **48** connected to a reactor support means **49** which interfaces with the threaded tube. The tube **48** may be rotated in a clockwise or counter clockwise fashion so as to allow adjustment of the distance between the plasma chamber **14** and the surface of the substrate **12**. In the embodiment illustrated, the distance between the plasma chamber and the substrate may be adjusted in the approximate range of 1 to 10 mm.

The reactor also has kinematic mounting means having three screws **50** equally spaced on a circle, each of which nest into a V-groove (not shown) on the top ceiling flange **40**. This arrangement allows adjustment of the angle of the terminal end **52** of the plasma chamber with respect to the surface of the substrate **12**.

While the present embodiment described above provides a means **46**, **47**, **48**, **49**, and **50** for positioning the plasma chamber **14** with respect to the surface of the substrate **12**, other adaptations such as permanently fixing the plasma chamber assembly and providing three-dimensional and multi-angular positioning of the substrate by a three-dimensional and multi-angular translation stages may be readily substituted. In fact, a fixed reactor configuration can be used so that the rf power, gas and coolant to the plasma reactor can be easily interfaced at atmospheric pressure.

The reactor system further comprises a bellows **54** attached between the ceiling flange **40** of the vacuum housing **36** and the second dielectric insulator **28** so as to provide a means for vacuum sealing the reactor **10** while the plasma chamber assembly is allowed relative movement within the reactor. A plurality of viewports **56** are provided for observation of the reaction.

Because the two-dimensional translation apparatus **45**, including a motivating means, operates within a corrosive and very low pressure environment within the vacuum chamber **30**, the long term reliability of the apparatus suffers. Also, because the motivating means requires lubricants and must operate in this harsh environment, a potential for contamination of the vacuum housing **30** exists. The present invention provides an improvement over existing translation apparatus and their corresponding motivating means by enclosing the motivating means in another housing within the vacuum housing **36** so that the motivating means is isolated from the application of the vacuum.

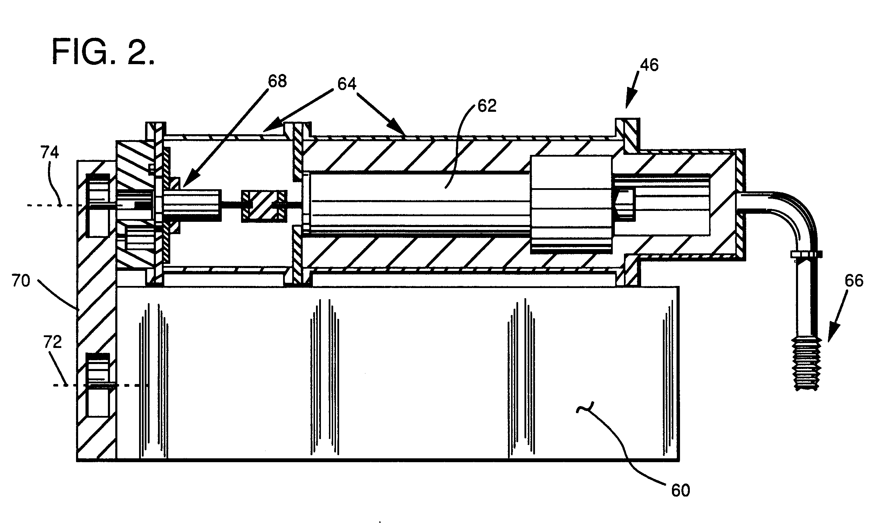

The two-dimensional translation apparatus **45** comprises two linear translations stages assemblies **46** and **47**. Figure 2 shows a schematic top view of one of the linear translation stages **46** of the present invention. The linear translation stage assembly **46** comprises a translating slide assembly **60** including a stage **61** for mounting the substrate thereon, a motor assembly **62** including an encoder and tachometer (not shown) for position and velocity measurements, a housing **64** enclosing the motor and drive assembly **62**, a flexible vent hose **66** to carry conductors for electrical power and sensors to the motor assembly and an airflow line for cooling the motor, a rotary feed-through **68** (vacuum to atmosphere), and a fold back motor mounting assembly **70**.

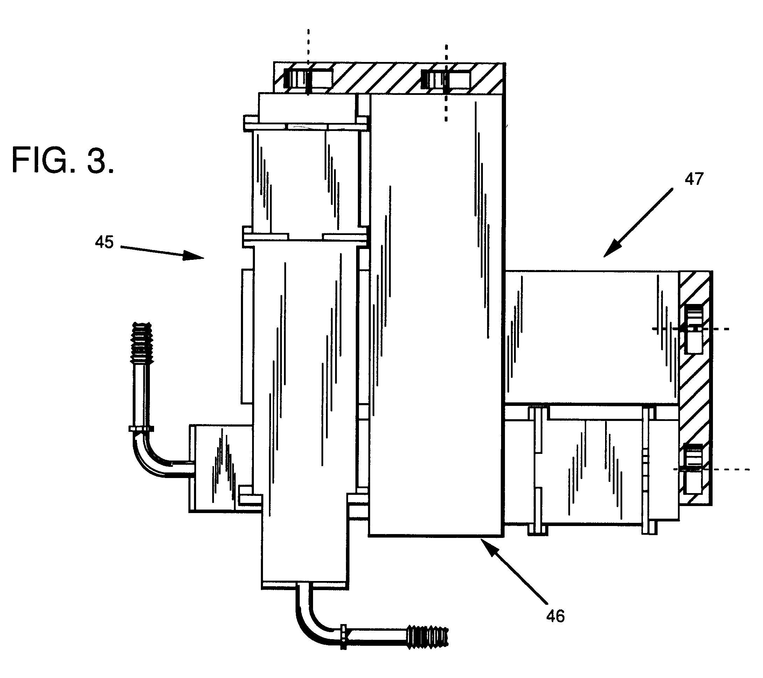

Fig. 3 shows that two-dimensional motion of the substrate with respect to the plasma chamber **14** is obtained by programmed motion of the two linear translation stage assemblies **46** and **47** stacked in a manner so as to have two perpendicular axes of linear motion. The first stage **46** is mounted to the vacuum chamber **30** floor and the second stage **47** is mounted on top of the first stage so as to provide support for the substrate holder. The linear motion requirements of each stage **46** and **47** can be obtained with a commercially available translational stage, however, the selection of a suitable stage must take into account that it will be operated long term in a corrosive, vacuum environment. Provided proper materials and lubricants are chosen, the translation slide assembly and bearings will operate without degradation. Materials that are suitable for the stage assembly include stainless steel (300 series), aluminum and polytetrafluorethyene (PTFE). Suitable lubricants include perfluorinated polyether oil loaded with PTFE, such as Fomblin™ grease and Krytox™ grease.

Although the translational slide assembly **60** can be operated in the corrosive vacuum environment, such operation is not feasible for the motor and drive assembly **62** and their associated positioned and velocity sensors.Even if prepared for operation in a vacuum, the motor assembly is troublesome because of the interaction with the corrosive gas environment which is characteristic of the plasma etching operation. The corrosive gas environment can introduce detrimental contaminants and, therefore, the critical components of the motor assembly **62** tend to have a short lifetime. It is not advisable to drive a multiple axis (multi-dimension) system from outside the vacuum chamber **30** because the drive system for one axis itself must move with the translational slide assembly. Thus, the demanding motion requirements, particularly the precise velocity control requirement, are difficult to meet if the motor assembly **62** is located outside of the vacuum chamber. Therefore, the present invention encloses the multi-dimensional translation apparatus within the vacuum chamber **30**.

The motor and drive assembly **62** is enclosed in the housing **64** so as to isolate and seal the assembly **62** from the effects of the vacuum and corrosive environment within the vacuum chamber **30**. The interior environment of the housing **64** is regulated and maintained at atmospheric conditions. Waste heat generated by the motor **62** and rotary feed-through **68** is exhausted out through the flexible vent hose **66** by flowing air or nitrogen through a small diameter flexible plastic hose (not shown) within the flexible vent hose **66**. An open end of the small diameter flexible plastic hose is position and close to the rotary feed-through **68** and as far away from an open end of the flexible vent hose as possible so as to create a flow of air or nitrogen within the housing.

The slide assembly **60** is driven by the motor and drive assembly **62** operating under atmospheric conditions coupled to the rotary feed-through **68**. The rotary feed through maintains a seal between the atmospheric environment within the housing **64** and the vacuum and corrosive environment of the vacuum housing **30**. A good high vacuum rotary seal is a commercially available ferrofluidic type rotary seal. Any chemically inert ferrofluid seal can be used as long as it does not react with the gas in the vacuum environment.

Rather than the driving the slide assembly **60** with the motor shaft axis **72** coupled directly to a lead screw axis **74**, a foldback motor drive configuration is used. In the foldback configuration, the motor drive axis and the lead screw axis are parallel and the motor axis can be coupled to the lead screw axis by a coupling means, such as a toothed belt. This configuration is used so as to reduce the envelope of stage motion and, thus allow for a much smaller vacuum chamber.

The substrate holder **44** which holds the substrate in position can be temperature controlled. The temperature control prevents long term heat build-up during the material removal process, and allows the substrate holder to operate slightly above room temperature to eliminate the possibility of condensation and associated contamination of the film surface.

Thus, what has been described is an apparatus for moving a substrate surface with respect to a plasma etching region of a plasma assisted chemical etching reactor. Because the motivating means of the apparatus is isolated from the harsh plasma etching environment, the apparatus provides long term precise position and velocity control of the substrate without the risk of contaminating the plasma environment.

## Claims

1. An apparatus for linear precision velocity and position control of a substrate surface proximal to a plasma region of a plasma assisted chemical etching reactor system, said apparatus comprising:
a non-contaminating linear translation stage;
a linear velocity and position control means to drive said translation stage with respect to the plasma region; and
a housing means encompassing said linear velocity and position control means to enclose said control means within a regulated atmospheric environment.

2. The apparatus of Claim 1, wherein the linear translation stage is fabricated from stainless steel, aluminum or polytetrafluroethylene, and
wherein the linear translation stage and the linear velocity and position control means include moving parts and wherein said moving parts are lubricated with perfluorinated polyether oil loaded with polytetrafluroethylene.

3. The apparatus of claim 1, wherein the linear translation stage includes a position control shaft and wherein the linear velocity and position control means comprises a motor, an associated drive train coupled to the position control shaft of said linear translational stage, and position and velocity sensors.

4. The apparatus of Claim 3, wherein the position control shaft includes a lead screw and wherein the control means is indirectly coupled to the lead screw of said stage by a rotary sealing means so as to allow the output of said motor and associated drive train to be passed through said housing while the regulated environment within said housing is maintained.

5. The apparatus of Claim 4, wherein the rotary seal means is a non-contaminating ferrofluidic type rotary seal.

6. The apparatus of Claim 1, wherein the housing means further comprises a flexible hose coupled to the interior of said housing means so as to provide the interior with ventilation, electrical power, data and control signals.

7. An apparatus for two-dimensional precision velocity and position control of a substrate surface proximal and orthogonal to a plasma region of a plasma assisted chemical etching reactor system comprising:
a) a substrate holder;
b)first and second linear translation stages, each having a lead screw shaft providing a means for movement thereof, and wherein the first stage is positioned on top of the second stage and in a manner such that lead screw shaft of the first stage is perpendicular to the lead screw shaft of the second stage.
c) first and second two motors each associated with a drive train and velocity and position sensors, positioned such that the first motor and drive train shaft is indirectly coupled to the lead screw shaft of the first translation stage, and the second motor and drive train shaft is indirectly coupled to the lead screw shaft of the second translation stage;
d) two housings, each encompassing a motor and its associated drive train andsensors so as to enclose each motor and its associated drive train and sensors in a regulated environment;
e) two ferrofluidic rotary seals each having a rotatable shaft passing through said housing, wherein said shaft is connected at one end to the shaft of said motor and drive train and at the other end to a means for rotatably engaging the lead screw shaft of said translation stage; and
g) two flexible hoses, each coupled to the interior of one of the housings so as to provide the interior of said housing with ventilation, electrical power and control signals.

8. The apparatus of Claim 7, wherein the substrate holder includes a means for controlling the temperature thereof.

9. An apparatus for linear precision velocity and position control of a substrate surface proximal to a plasma region of a plasma assisted chemical etching reactor system, said apparatus comprising:
a non-contaminating linear translation stage;
a linear velocity and position control means to drive said translational stage with respect to the plasma region; and
a housing means encompassing said linear velocity and position control means to enclose said control means within a regulated atmospheric environment.

10. The apparatus of Claim 9, wherein the position control shaft includes a lead screw and wherein the control means is indirectly coupled to the lead screw of said stage by a rotary sealing means so as to allow the output of said motor and associated drive train to be passed through said housing while the regulated environment within said housing is maintained, and
wherein the rotary seal means is a non-contaminating ferrofluidic type rotary seal.
